# EUROPEAN PATENT APPLICATION

(11) **EP 1 107 657 A2**
(43) Date of publication of application: **13.06.2001**
(21) Application number: 00310747.1
(22) Date of filing: 04.12.2000
(51) Int. Cl.: H05K 7/20, H01L 23/467

(54) **Means for dissipating heat in electrical apparatus**

(30) Priority: 08.12.1999 GB 9928862
(71) Applicant: Pace Micro Technology Ltd, Saltaire, Shipley BD18 3LF (GB)
(72) Inventor: Bristow, Anthony, Northowram, Halifax HX 7JF (GB); Cross, Stephen, Rochdale, Lancashire OL16 4BH (GB)
(74) Representative: Wood, Graham

(57) **Abstract**

The invention relates to the provision of a cooling effect on electrical or electronic components which are within a housing and which in combination form electrical apparatus. Conventional cooling means such as fans can be too noisy for many forms of electrical apparatus and in accordance with the present invention there is provided a heat dissipation formation which is provided with an inlet and outlet connected by a passage within the housing. The formation can be formed to encourage the flow of air through the same and can be formed to pass close to or in contact with components which need to be cooled. The flow of air allows heat to be transferred to the same and the heated air flows out of the housing thereby cooling the components in the same.

## Description

The invention to which this application relates is a means for allowing the dissipation of heat from within an apparatus housing and/or from a particular component or components within the electrical apparatus housing. The invention provides the dissipation of heat without the use of powered dissipating means such as fans and therefore reduces the cost of the apparatus and improves the simplicity of the design of the same.

The use of electrical components in electrical apparatus such as receivers(known as set-top boxes), pc's, television sets and the like is common place and a well-known problem with various forms of electrical apparatus is that the electrical components and integrated circuits within the apparatus housing generate considerable heat when the electrical apparatus is in operation or even when in standby mode. While one particular component or integrated circuit may in itself not generate a significant amount of heat, when the components and circuits are combined to form the electrical apparatus operating and processing system within a housing, the combined heat which is generated can be such that operation of various components and integrated circuits can be damaged or restricted. The problem can be exacerbated by the restricted space within the electrical apparatus housing such as, for example, receivers or set top boxes which are typically required to be fitted between the video and television in relatively confined spaces and therefore the air space within the housing of the apparatus can be quite restricted. This can increase the build-up of heat in the apparatus housing.

As the problem is well-known, there are a number of known solutions, the most common of which is to provide an electrically powered fan or fans within the apparatus. The fans are powered by the power supply to the electrical apparatus and serve to draw heated air out of the housing into the surrounding environment and by generating the air flow through the apparatus, cool the components within the housing. A further problem with fans is that no matter how many attempts are made, the same can be noisy and are prone to vibration. In some areas, where the apparatus itself is noisy when operating, the noise of the fan may be irrelevant but in many types of electrical apparatus any noise which is emitted from the apparatus can detract from the enjoyment. Apparatus which is particularly prone to this sort of problem are set-top box receivers and/or musical equipment and the like.

The aim of the present invention is to provide a means of dissipating heat which is generated within an electrical apparatus housing without the need to provide powered devices thereby reducing the draw on the power supply to the apparatus and also overcoming the creation of noise which can be generated by conventional powered heat dissipating means.

In a first aspect of the invention there is provided electrical apparatus comprising a series of components and a power supply to the components to allow operation of the same, said components located within a housing and characterised in that a heat dissipation formation is provided in the housing, said formation having an inlet leading into a passage along which air is induced to flow and which passage leads to an outlet and, as air passes through the heat dissipation formation, heat transfer takes place which heats the air in the passage and which heated air exits via the outlet thereby cooling the components and/or the air in the housing.

In one embodiment both the inlet and outlet are provided at spaced locations within the housing with the inlet located so as to draw in colder air. In an alternative embodiment one or both of the inlet and outlet are located or open into the environment outside of the electrical apparatus. Preferably, the outlet is positioned to allow the heated air to escape from the housing into the surrounding environment. Yet further, it is preferred that the inlet and outlet are spaced as far apart as possible.

The heat dissipation formation in a preferred embodiment acts in a similar manner to a building chimney and comprises a passage which is formed as required with reference to the dimensions of the housing in which the same is to be provided, with reference to the location of the components to be cooled in the housing and with reference to the requirements to allow the flow of air through the formation. While it is preferred that the flow of air is encouraged by the formation of the heat dissipating chimney in the apparatus, it is also possible that in one embodiment where there are no noise considerations, that a fan unit may be provided although in this embodiment the fan unit may only be required to be of sufficient strength to generate and induce the air flow rather than be sufficiently powerful to expel the heated air from the apparatus housing.

A further advantage of the heat dissipation formation of this invention is that it can be relatively easily fixed in position in the electrical apparatus and is not susceptible to vibration or the generation of other noise during operation of the apparatus. As the heat dissipation formation can be fixed firmly in position with respect to the housing and the apparatus in general the same is positionable at the time of assembly of the apparatus and can be held in that position during transit and subsequent use of the apparatus.

In one embodiment the heat dissipation formation can be provided with a series of apertures which are arranged close to components which are known to heat up in the apparatus housing and thereby allow the flow of heated air from the vicinity of said components into the heat dissipation formation and out of the apparatus housing and the introduction of the heated air can be provided to allow the heated air entering the passage to induce the flow of air through the same.

In an alternative embodiment, no further apertures are provided in the heat dissipation formation other than the inlet and outlet but the heat dissipation formation is formed so as to pass close to, or even in contact with, the components in the apparatus which require to be cooled. This allows the heat from the heated air to be conducted through the sheet material used to form the heat dissipation formation and heat the air in the passage. By generating the flow of cooled air into the passage and the flow of heated air out of the passage, so a cooling effect is created on the component adjacent to the dissipation formation.

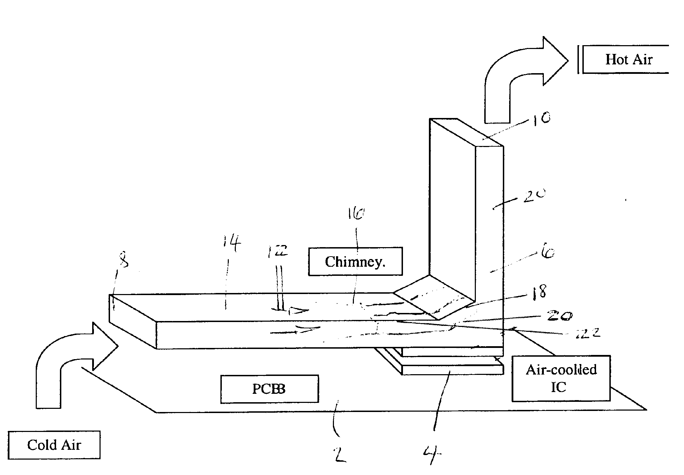

Specific embodiments of the invention will now be described with reference to the accompanying drawing, which shows, an example of one embodiment of the heat dissipation formation in accordance with the invention.

Referring to the drawing, there is shown a printed circuit board 2 on which there is provided, for illustrative purposes only, an integrated circuit 4, although it should be appreciated that in practise, the printed circuit board will include many other components and features attached or connected thereto. Also, in practise, the printed circuit board 2 is provided within a casing or housing which forms the outer dimensions of the apparatus and in many instances, the casing can be relatively slim due to other dimensional constraints which limits the amount of space which is available within the housing for cooling arrangements and the like. In accordance with the invention, the integrated circuit 4 is known to heat up during operation of the apparatus and there is a need for cooling of the integrated circuit to allow the same to be operational over a prolonged period of time. In order to achieve this, there is provided a heat dissipation formation 6 which has an inlet 8 and an outlet 10 spaced therefrom and, intermediate the inlet and outlet a passage which is formed so as to encourage the flow of air from the inlet to, and out of, the outlet 10 as indicated by the arrows 12. The encouragement for the flow can be the narrowing of the passage 14 as is indicated at the neck section 16 and/or the provision of gradients in the formation as indicated by the section 18 and/or vertical arrangements 20 as shown and it should be appreciated that any combination of these features can be used to encourage the air flow.

The inlet and outlet are both located to allow, in the first instance, cold air to be drawn into the heat dissipation formation and, secondly, heated air to be emitted from the housing away from the apparatus to provide the cooling effect. As the portion 20 of the heat dissipation formation is positioned adjacent to the integrated circuit 4, so heat generated by the integrated circuit passes into the air passing through the heat dissipation formation and so is drawn away from the integrated circuit and out of the apparatus, thereby providing a cooling effect on the integrated circuit.

The provision of the heat dissipation formation according to the present invention allows for the generation of cool air flow in relation to an integrated circuit without the need for a fan although, if necessary and if possible, a fan could be arranged to encourage air flow through the heat dissipation formation.

In one embodiment, the heat dissipation formation can be made from a mouldable plastic material to any required form to provide the characteristic of flow of air and the same can be formed in a manner which is dependent on the required speed of flow of air and it is envisaged that the optimum shape for the particular electrical apparatus can be designed with respect to the apparatus shape and particular components which are to be cooled. The heat dissipation formation can be formed and adhered in position in the apparatus during the manufacturing process. In one example, the temperature above the surface of the integrated circuit can rise to a level which is around 20° above the ambient temperature within the apparatus and at that stage hot air starts to rise at a steady enough rate to cause air to move along the passage 14. When this occurs, hot air is expelled from the outlet 10 and cold air is drawn from a cooler area either within the apparatus or externally of the apparatus and this colder air flows through a smaller passage 22 above the surface of the integrated circuit to cool the same and transfers heat into the cold air which flows along the passage. As this function is repeated a capillary action occurs and the process continues until the apparatus is turned off and cools down. It may be possible to add apertures to the upper part of the heat dissipation formation to encourage air flow initially.

In a further feature of the invention it is possible to provide heat sinks at appropriate locations in the heat dissipation formation to increase the temperature change which occurs within the heat transfer chamber 20.

## Claims

1. Electrical apparatus comprising a series of components and a power supply to the components to allow operation of the same, said components located within a housing and characterised in that a heat dissipation formation is provided in the housing, said formation having an inlet leading into a passage along which air is induced to flow and which passage leads to an outlet and, as air passes through the heat dissipation formation, heat transfer takes place which heats the air in the passage and which heated air exits via the outlet thereby cooling the components and/or the air in the housing.

2. Apparatus according to claim 1 characterised in that the inlet and outlet are provided at spaced locations within the housing.

3. Apparatus according to claim 2 characterised in that the inlet is located so as to draw in air which is relatively cool compared to air within the housing.

4. Apparatus according to claim 1 characterised in that one or both of the inlet and outlet are located or open into the environment outside of the housing.

5. Apparatus according to claim 4 characterised in that the outlet is positioned to allow the heated air to exit from the housing into the surrounding environment.

6. Apparatus according to claim 1 characterised in that the heat dissipation formation passage is located in the housing with reference to the location of the components in the housing.

7. Apparatus according to claim 1 characterised in that a fan unit is provided in conjunction with the heat dissipation formation to induce the air flow through the formation.

8. Apparatus according to claim 1 characterised in that the heat dissipation formation is formed from sheet material and mechanically located with the housing.

9. A heat dissipation formation for the provision of a cooling effect on one or a number of electrical or electronic components of electrical apparatus, said formation comprising a spaced inlet and outlet connected by a passage, formed to induce the flow of air from the inlet to the outlet and as the air passes therethrough heat transfer from the component or components acts to heat the air and provide a cooling effect on the component or components.

10. A heat dissipation formation according to claim 9 characterised in that the component or components are mounted externally of the walls of the passage but in close proximity to or in contact with the component so as to maximise heat transfer.

11. A heat dissipation formation according to claim 9 characterised in that at least one aperture is provided along the passage.

12. A heat dissipation formation according to claim 11 characterised in that the aperture is positioned with respect to a component which is known to require cooling during operation.

13. A heat dissipation formation according to claim 9 characterised in that the passage is formed of sheet material which allows the conduction of heat therethrough.
